# EUROPEAN PATENT APPLICATION

(11) **EP 3 410 504 A1**
(43) Date of publication of application: **05.12.2018**
(21) Application number: 17174303.2
(22) Date of filing: 02.06.2017
(51) Int. Cl.: H01L 41/04, H01L 41/09, H01L 41/193

(54) **EAP ACTUATOR AND DRIVING METHOD**

(71) Applicant: Koninklijke Philips N.V., 5656 AE Eindhoven (NL)
(72) Inventor: VAN DE MOLENGRAAF, Roland Alexander, 5656 AE Eindhoven (NL); VAN DEN ENDE, Daan Anton, 5656 AE Eindhoven (NL); JOHNSON, Mark Thomas, 5656 AE Eindhoven (NL)
(74) Representative: de Haan, Poul Erik

(57) **Abstract**

The proposed concept of driving an electroactive polymer actuator (70) makes use of a look up table (74) with data representing changes in actuation level over time for switching from a first actuation state to a second actuation state. A controller (76) controls a driver (72) to apply a drive waveform between two drive voltages taking into account said look up table data. In this way, the non-ideal response (hysteresis, creep) of the actuator material is taken into account so that the actuator may be operated as quickly and precise as possible, particularly suitable for ferroelectric relaxor polymers such as PVDF.

## Description

### FIELD OF THE INVENTION

This invention relates to electroactive polymer actuators and devices or systems including such actuators as well as to methods for driving such actuators. It further relates to a computer-implemented invention for performing the methods.

### BACKGROUND OF THE INVENTION

Electroactive polymer actuators are devices that can transform an electrical input to (mechanical) output such as e.g. force or pressure or vice versa. Thus, EAP actuators can be used as mechanical actuators and, depending on the EAPs used, often also as sensors. To this end they comprise electroactive polymers (EAP) which can deform or change shape under the influence of an actuation stimulus or signal. Some examples of field-driven EAPs include Piezoelectric polymers, Electrostrictive polymers (such as PVDF based relaxor polymers) and Dielectric Elastomers, but others exist.

EAP actuators can be easily manufactured into various shapes allowing easy integration into a large variety of systems such as for example medical or consumer devices. Further, EAP based actuators/sensors combine high stress and strain with characteristics such as: low power, small form factor, flexibility, noiseless operation, accurate operation, the possibility of high resolution, fast response times, and cyclic actuation.

Typically, their characteristics render an EAP actuator useful for e.g. any application where little space is available and in which a small amount of movement of a component or feature is desired, based on electric actuation. Similarly, the technology can be used for sensing small movements.

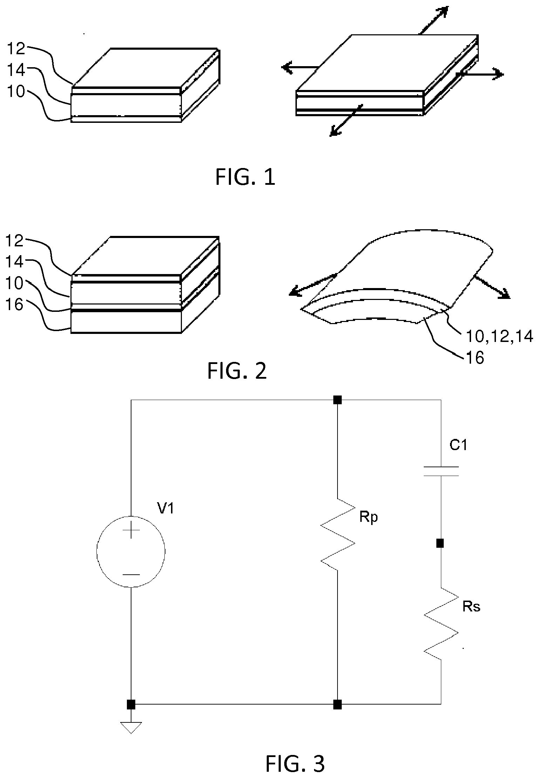

Figures 1 and 2 show two possible operating modes for an exemplary EAP actuator. It comprises an EAP structure including an EAP layer 14 sandwiched between electrodes 10, 12 on opposite sides of the EAP layer 14. Figure 1 shows an actuator which is not clamped by (attached to) any carrier layer or substrate. A drive voltage applied to the electrodes is used to cause the EAP layer to expand in all directions as shown. Figure 2 shows an actuator which is designed so that the expansion arises only in one direction. In this case a similar EAP structure as the one of Figure 1 is supported and clamped, i.e. mechanically attached to a carrier layer 16. A voltage applied to the electrodes is again used to cause the EAP layer to expand in all directions as indicated for Figure 1. However, the clamping confines the actual expansion such that a bowing of the entire structure is caused instead. Thus, the nature of this bending movement arises from the interaction between the passive carrier layer and the active layer which expands when actuated.

It appears that when an EAP actuator, such as the one of Figures 1 and 2, is activated using an electrical driving scheme, the actual desired mechanical actuation response deviates from the desired with respect to timing and/or actuation state. For example, a certain time delay occurs between the start of driving and reaching a desired actuation state. This discrepancy hampers application of EAP devices as e.g. fast and accurate mechanical response is difficult.

Furthermore, a reproducible degree of actuation also requires that the actuator deforms by the same amount irrespective of the prior history of actuation (such as polarity of the previous driving signal, delay between changes in signal etc.). The actuation history, in particular the delay-time history, also has an impact on the actuation response.

### SUMMARY OF THE INVENTION

It is an object of the invention to provide an improved EAP actuator with respect to the hereinbefore mentioned discrepancy.

This object is at least partly achieved by the invention as defined by the independent claims. The dependent claims provide advantageous embodiments.

The device and method of the invention uses an actuator that comprises an electroactive polymer structure for providing a mechanical actuation output dependent on a drive signal supplied to it. Such signal can be applied using electrodes. Thus, a first drive voltage makes the structure attain a first actuation state while a second drive voltage different from the first voltage makes it attain a second actuation state different from the first actuation state. The electroactive polymer structure comprises an electroactive polymer (EAP) which is capable of changing its shape upon application of the drive signal. Examples of such EAP structures are described with reference to Figures 1 and 2, but others exist and the invention is not limited to these examples.

An EAP structure has an electrical impedance including a capacitance of the capacitor defined by the structure's EAP and electrodes and/or other layer configuration. The mechanical actuation of the EAP structure is dependent on the electrical field within and thus electrical charge on the effective capacitor. This is because the actuator is either electric field driven and such a field is dependent on charge, or is current driven, where, again, the current is caused by an electric field. Therefore, the 'intrinsic' speed of switching of the actuator is thus dependent on the charging speed of this effective capacitor. Due to the impedance a capacitive charge, needed to reach a certain mechanical actuation position of the EAP structure, requires time to build up to a specific level. Such a charging level is therefore only reached after a certain multiple of a characteristic time constant. Usually, after a time duration of 5 times this characteristic time constant, the maximum actuation extension (or end position) is reached for a specified drive signal. For applications where a fast response is needed with a limited delay time, or a higher frequency of operation is required, this behavior might be a disadvantage and would hinder the usage of EAP actuators.

It is also believed that there is an issue of remnant polarization as a function of electric field in certain types of field-driven EAP actuator. This also makes the actuation response dependent on the historical driving of the actuator.

According to examples in accordance with the invention, there is provided an actuator device comprising:
an electroactive polymer structure for adopting at least a first actuation state and a second actuation state different from the first actuation state, the first actuation state having a first drive voltage associated with it and the second actuation state having a second drive voltage associated with it;
a driver adapted to apply drive voltages to the electroactive polymer structure for switching it from the first actuation state to the second actuation state;
a look up table which stores look up table data which represents the change in actuation level over time after actuation from the first drive voltage to the second drive voltage; and
a controller to control the driver to apply a drive waveform for transitioning between the first and second actuation states which takes into account the look up table data.

This device uses a look up table to store a response of the actuator over time to a particular drive level.

The response may be stored for a drive level change from a stable non-actuated state (e.g. 0V drive signal) to an actuated state (e.g. 100V drive signal). However, the change in actuation state may be stored for multiple pairs of drive levels, representing the change in actuation state from a first stable drive level (e.g. 0V, 50V, 100V, 150V, 200V) to another higher or lower drive level (e.g. a step of 50V higher than the first drive level). In this way, for a set of possible pairs of sequential actuation levels (as will be present in the use of the actuator device in a particular application), the relaxation behavior is modeled in a look up table.

With sufficient pairs of actuation levels, it is possible to extrapolate between the stored look up table data to enable the time response to be predicted for driving from any first actuation level to any second actuation level.

Based on knowledge of the physical actuation behavior, the actuation waveform may then be selected to achieve a desired mechanical response. This provides full control of actuator displacement, enabling the device to have improved performance. The invention thus enables reproducible actuation levels based on the use of special driving schemes, in particular with a look-up table based approach. The driving voltage waveform, i.e. the driving voltage levels and their durations, may be adjusted depending upon the hysteresis profile of the device (i.e. the polarity and direction of the driving pulses) and also the time delay between successive steps in actuation.

The look up table may store a set of discrete actuation level points over time of a logarithmic function, for the drive voltage for each of a plurality of different first and second drive voltages. This logarithmic function enables the actuation response to be predicted over time for an applied actuation signal. The function can be extrapolated from the discrete set of points.

The look up table may store data representing the effect of a hold period at the first actuation state before driving to the second actuation state. In this way, the historical drive levels, and in particular the duration at the preceding drive level, is taken into account. This historical driving information influences how the actuator responds to new drive voltages, and thus by taking the historical driving into account, more accurate actuation is possible.

The data representing the effect of the hold period may for example comprise a slope of the function of displacement versus actuation voltage level. The data representing the effect of the hold period may for example comprise a starting value of the displacement when the transition from the first actuation state to the second actuation state commences.

The electroactive polymer structure preferably comprises a field-driven electroactive polymer and in particular a PVDF relaxor polymer actuator. This type of field driven EAP actuator shows remnant polarization as a function of electric field.

Examples in accordance with another aspect of the invention provide a method of driving an actuator device which comprises an electroactive polymer structure for adopting at least a first actuation state and a second actuation state different from the first actuation state, the first actuation state having a first drive voltage associated with it and the second actuation state having a second drive voltage associated with it, wherein the method comprises:
applying a first drive voltages to the electroactive polymer structure for holding it in the first actuation state; and
providing a voltage waveform between the first drive voltage and a second drive voltage for driving the actuator device to the second actuation state,
wherein the voltage waveform is determined by addressing a look up table which stores look up table data which represents the change in actuation level over time after actuation from the first drive voltage to the second drive voltage.

By taking the actuator response function into account, a drive voltage can be applied which result in a desired actuation level after a certain time.

The method may comprise forming a logarithmic function of the actuation level over time for each of a plurality of different first and second actuation states, by extrapolating between a set of discrete points.

The method may comprise storing in the look up table data representing the effect of a hold period at the first actuation state before driving to the second actuation state. In this way, the drive history is taken into account when determining the future actuator response to a drive signal change.

The data representing the effect of the hold period may comprise a slope of the function of displacement versus actuation voltage level. It may additionally or alternatively comprise a starting value of the displacement when the transition from the first actuation state to the second actuation state commences.

The method may be implemented at least in part in software.

### BRIEF DESCRIPTION OF THE DRAWINGS

Examples of the invention will now be described in detail with reference to the accompanying schematic drawings, in which:
Figure 1 shows a known EAP actuator, which is unconstrained and thus expands in plane;
Figure 2 shows a known EAP actuator, which is constrained and thus deforms out of plane;
Figure 3 shows an equivalent circuit of an EAP actuator;
Figure 4 shows a plot of the displacement of a PVDF relaxor polymers actuator in response to a sawtooth drive waveform;
Figure 5 shows how the sawtooth driving scheme of Figure 4 can be adapted to introduce delays;
Figure 6 shows actuation response to the sawtooth driving schemes of Figure 5;
Figure 7 shows an actuator device in accordance with the invention;
Figure 8 shows the displacement as function of delay for three driving voltages;
Figure 9 shows the slope of different voltage ranges as a function of a previous delay;
Figure 10 shows the linear behavior of displacement vs. voltage in a limited voltage range of 50V; and
Figure 11 shows effect of different delays on plot of Figure 10.

### DETAILED DESCRIPTION OF THE EMBODIMENTS

The invention provides a method of driving of an electroactive polymer (EAP) actuator and provides an EAP actuator capable of performing or adapted to perform the method. With the invention an adjusted drive scheme is used to more accurately change the actuation from one actuation state (the first or start actuation state) to another actuation state (the second or desired actuation state). In particular, the actuator makes use of a look up table which stores look up table data which represents the change in actuation level over time for actuation from the first actuation state to the second actuation state. A driver applies a drive waveform between the first and second drive voltages which takes into account the look up table data. In this way, the response of the actuator is taken into account, for example based on different historical drive levels as well as the response of the actuator to a static drive level, so that the actuator may be operated as quickly and accurately as possible.

The first actuation state can be a rest state (also referred to as a non-actuated state) while the desired state can be an actuated state or vice versa. The first actuation state can be an actuated state while the desired state can be an even further actuated state. However, the desired actuation state can also be a less actuated state. The invention will improve switching from one to another state in either situation. The lookup table enables the speed and accuracy of response of the EAP structure (and thus actuator) to be improved without damaging the EAP structure and can do so without substantial actuation overshoot.

Typically, an EAP actuator and its EAP structure include electrodes for receiving an electrical drive signal supplied to it by a driver. The driver can therewith control the actuator. The driver usually includes a driving circuit for providing the required electrical drive signal to the electrodes. The electrical drive signal is typically a voltage drive signal for the field-driven actuators to which the invention applies.

When the EAP structure is being activated, the driver applies (or generates) a voltage amplitude (alternating such as AC, slowly varying, quasi static, or static such as DC) to the electrodes to therewith bring the EAP structure into the desired actuation state (e.g. actuation position).

Both EAP structures and electronic driving circuits are not ideal. For example, an electronic driving circuit always has internal resistances. The actuation response of an EAP actuator is therefore not only a function of the EAP structure itself but also of the driving circuit. In order to reduce the impact of the driver, the operating voltage for the EAP is usually stored in a capacitor, parallel to the EAP, and in terms of actuation this stored voltage is fed by an electronic switch (e.g. transistor, MOSFET) to the EAP actuator.

Since an EAP actuator behaves as an electrical load with an impedance for the driver (voltage or current driver), upon setting a certain voltage or current by the driver, the voltage difference developing across the actuator electrodes usually is not entirely in sync with the setting of the signal.

More specifically, and with reference to Figure 3, from an electrical point of view, an EAP actuator (such as the one of Figure 1) can be described as giving rise to a series connection of a resistor Rₛ and a capacitor C1, both in parallel with a further resistor Rₚ. This, so called, equivalent RC circuit describing the EAP actuator, is then connected to a driver. While other RC circuits could be used for describing an EAP structure, the one of Figure 3 describes an EAP to the first order quite well.

The EAP structure deforms as a function of the electric field within the capacitor and thus as a function of the charge on this capacitor which again depends on the applied voltage amplitude provided by the driver. If the EAP is being deactivated, the applied voltage can be disconnected and accordingly the EAP will slowly discharge via its internal parallel resistance Rs and finally will go back to its initial position. However, other discharge methodologies can be applied in specific circumstances such as providing other voltage amplitudes as will be further described herein below.

Essentially the RC series circuit defines the electrical time constant τ= Rₛ·C1 (in seconds) which is an important parameter describing the temporal behavior of such a configuration. As said, the mechanical displacement (i.e. movement) of an EAP actuator is related to the charge Q on the capacitor C1, which is defined by the applied voltage V1 and the capacitance itself (Q= C·V). Since the capacitance of the capacitor is a 'fixed' component with a fixed capacitance which depends on the design and construction of the actuation structure of the device (i.e. although the capacitance varies somewhat during driving, it is in first instance defined by the design configuration and EAP used), the applied voltage is the dominant parameter describing the mechanical deformation of an EAP at a steady state.

Before a steady state is reached however, the charge stored on the capacitor C1 (and thus the voltage over the capacitor) determines the instantaneous level of actuation and hence displacement. While the voltage V1 provided by the driver is used to drive the EAP structure (equivalent circuit), it is the voltage across the capacitor C1 that determines the level of actuation or displacement. Thus, it is an important notion that upon switching of an EAP structure to a desired actuation level, the mechanical response of the EAP structure will not overshoot the desired actuation level if an overdrive voltage V1 is applied to the structure so long as the voltage across the capacitor remains below the voltage corresponding to the desired actuation level.

The invention is based on the recognition that the actuation behavior cannot be based simply on the equivalent circuit shown. Instead, the EAP material may become electrically polarized by the drive levels provided, and this influences the actuation response. This invention is thus of particular application to field-driven EAP actuators showing remnant polarization as a function of electric field, as will become apparent from the description below.

The primary issue being addressed is reproducibility and accuracy of the actuation state. Speed is a secondary issue (and indeed a slower response may be tolerated to achieve better accuracy).

The source of the poor reproducibility lies in the device itself - especially changes within the device which are caused by previous electric fields across the device, such as this remnant electrical polarization. The electrical polarization is equivalent to the mechanism which takes place in of piezoelectric materials. Essentially, there are parts of the EAP material which can be electrically polarized. This remnant polarization is dependent on the prior history of the driving voltages.

The invention has been derived based on analysis of experimental results. The experiments aimed to identify the input function needed to drive an actuator accurately based on the delay-based driving-history.

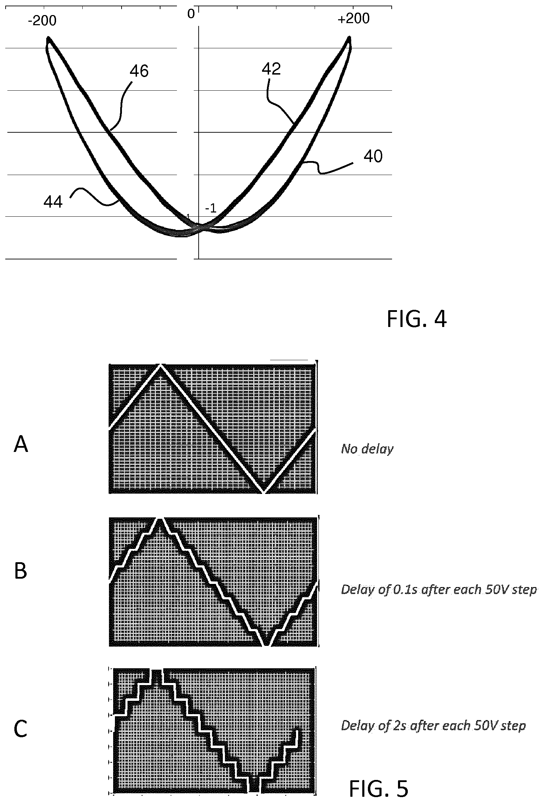

Figure 4 shows a plot of the displacement of a PVDF relaxor polymers actuator in response to a sawtooth drive waveform which cycles linearly between -200V and 200V with a frequency of 1Hz. The x-axis is voltage and the y-axis is displacement.

Active driving takes place in the first part of the hysteresis curve, namely part 40 in Figure 4, going from 0V to 200V and part 44 going from 0V to -200V. The rate of change of displacement is greater (so a steeper curve) during driving to an increased (absolute) voltage than during relaxation to a decreased voltage (parts 42 and 46). The plot cycles in the order 40, 42, 44, 46. During the relaxation parts, the field is progressively removed after which the molecules return from the ferroelectric all trans conformation, to the paraelectric phase, (a mixture of trans-gauche (TGTG') and T3GT3G' conformations).

However, all parts of the curve may be considered to show activation, either from a higher voltage to a lower voltage or from a lower voltage to a higher voltage.

In a first example, the system of the invention takes account of delay periods during which the actuator is held at a desired drive voltage. The experiments conducted aim to determine the behavior of the actuator as a result of delays during which the actuator is held at one level before actuation to a new level as well as delays during which the actuator is held at the new level.

The nature of the response to prolonged static actuation is first discussed.

To obtain behavior which is only influenced by a current delay (i.e. the length of time the current drive level is held), other prior history of actuation (such as polarity of driving signal) is cancelled by a number of bipolar run-in cycles before experimenting with delays. These run-in cycles ensure a steady-state situation. This means that a first experimental cycle without altering delay periods should match with the last cycle of the run-in series. These run-in cycles have the effect of randomizing the polarization.

The overlap of all signals in Figure 4 (there are five cycles plotted on the same graph) demonstrates that a steady state behavior is reached.

The sequence of bipolar cycles (i.e. the sawtooth cyclic operation of Figure 4) can then be provided with delays, and the displacement can then be monitored during such a delay. Delays are built in at different driving voltages.

Figure 5 shows how the sawtooth driving scheme of Figure 4 can be adapted to introduce these delays. Each of the plots shows voltage versus time, with the voltage cycling between -200V and +200V.

Figure 5A shows the basic sawtooth waveform which is used for the run-in series.

Figure 5B shows a first delay of 0.1s applied after each 50V step.

Figure 5C shows a second, larger, delay of 2s applied after each 50V step.

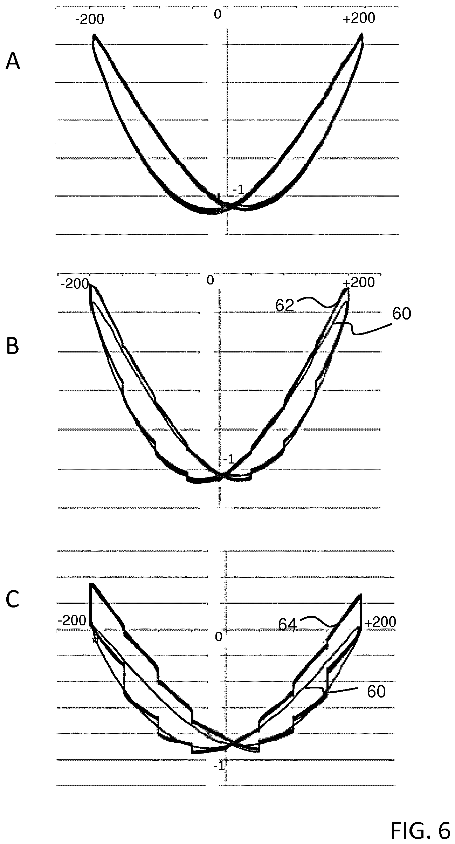

Using the driving schemes as shown in Figure 5 leads to the results shown in Figure 6.

Figure 6A relates to the continuous sawtooth waveform and thus corresponds to Figure 4.

Figure 6B relates to the sawtooth waveform of Figure 5B. Plot 60 shows the stable response which is achieved at the end of the run-in series, i.e. corresponding to the waveform of Figure 6A. Plot 62 shows that the response with the introduced delay (showing 5 cycles) deviates from the steady state response.

Figure 6C relates to the sawtooth waveform of Figure 5C. Plot 60 again shows the stable response, i.e. corresponding to the waveform of Figure 6A. Plot 64 shows that the response with the introduced delay (showing 5 cycles) deviates even further from the steady state response.

Figure 6C shows most clearly that at each voltage level, the actuation level is not static but undergoes a step before the next voltage level is applied.

Figure 6 also shows that there is an increase of total displacement when there is an increase of delay-time. This has been demonstrated also by studying different delay times. During a delay period, the displacement continues to alter.

The displacement after each delay (i.e. between the steps) shows a different slope in the hysteresis-curve compared to the hysteresis without delay (the steady state response at the last run-in cycle) during actively addressing the actuator.

Figure 6C shows that there are step changes in actuation both when the voltage is increasing and when it is decreasing. The polarization is clearly changing as a result of a transition to a higher voltage or to a lower voltage. The electrically polarized parts are becoming less uniformly polarized when the voltage reduces (they depolarize themselves to reduce total energy of the system).

Without wishing to be limited by theory, the mechanism behind this behavior is believed to relate to polarization domains which strive for a state of minimum energy, resulting in maximum displacement.

The invention is based on enabling full control of the actuator properties, in particular the actuator displacement by using special driving schemes, in particular using a look-up table based approach to obtain accurate device actuation. In particular, the driving voltages and their duration may be adjusted depending upon the hysteresis profile of the device (i.e. the polarity and direction of the driving pulses) and the time delay between successive steps in the actuation waveform. By taking these parameters into account, it becomes possible to drive the actuator to the same amplitude of actuation irrespective of delay time.

The experiments shown above indicate that the highest actuation levels are achieved when relatively long delays (or relatively slow voltage ramps) are used. This can be understood as such longer time periods are required for the materials to reach equilibrium (i.e. polarization domains have reached a state of minimum energy). These equilibrium actuation levels may thus be used as reference levels which are to be aimed at by use of the look-up table actuation scheme.

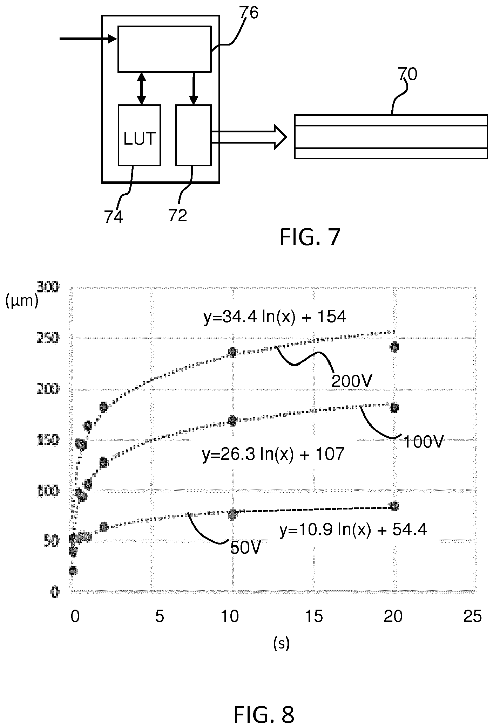

Figure 7 shows an actuator device in accordance with the invention, comprising an electroactive polymer structure 70 which can be driven between at least two actuation states each having an associated drive voltage. A driver 72 applies drive voltages to the electroactive polymer structure for switching it between actuation states. A look up table 74 stores look up table data which represents the change in actuation level over time for actuation between actuation states. A controller 76 controls the driver to apply a drive waveform which takes into account the look up table data.

The way the look up table data is used will now be explained.

In the first example, the effect of a delay at a static drive voltage is considered. For the purposes of explanation, it is assumed that the actuator has a displacement associated with a driving voltage of 100V. It has been observed that the longer the delay before increasing the actuation voltage (to 150V for example), the displacement keeps increasing whilst holding the actuation voltage at 100V.

During the delay, the actuator displacement will change towards a stable situation where the polarization domains have reached a state of minimum energy at that specific static voltage.

Table 1 below shows the displacement (in µm) at three static voltages (100V, 150V and 200V) as a function of delay (in seconds).

**Table 1**

| | delay (s) | 0.1 | 0.5 | 0.67 | 1 | 2 | 10 | 20 |
|---|---|---|---|---|---|---|---|---|
| 100V | | 21.3 | 52.7 | 55.5 | 54.2 | 63.9 | 76.8 | 84.6 |
| 150V | | 40.8 | 97.9 | 94.2 | 106.3 | 127.7 | 169.1 | 181.9 |
| 200V | | 52.7 | 146.4 | 144.9 | 163.3 | 182.3 | 235.9 | 241.3 |

The measurement position and the actuator properties (based on material composition) will of course lead to different displacements. However, regardless of the measurement position and the actuator properties is the trend of displacement as function of delay.

This trend can be seen in Figure 8 which shows the displacement as a function of delay for the three driving voltages 100V, 150V, 200V. It has been established that each plot can be fitted with a logarithmic function.

This trend indicates that there are fast reacting species and slow reacting species at each specific static actuation voltage.

Using this logarithmic function, the look-up table can be generated based on a limited number of measurements. The look-up table will be application specific in the sense that the driving history associated with that application will influence the displacement profiles, and actuator specific in that the material composition and actuator architecture will influence the displacement.

The plots of Figure 8 show the change in actuation level over time for actuation from a first actuation level to a second actuation level (at time zero). The time after the step change in actuation then comprises a delay time at the second actuation level.

The look up table is populated using an approach which collects only a limited number of data-points for the logarithmic function described above.

Each plot in Figure 8 starts with a step from 0V to the 100/150/200 level. Thus, these plots are used for actuation from a 0V level, and are not used if the previous voltage was not 0V before (or if the actuator was not fully stable at 0V).

Once there is a regular (production) device the look-up table can be built using experiments and then delivered with the device and driving system. Plots such as Figure 8 can be provided for steps between different voltage values, and then extrapolation between different plots may be used to determine the response to voltage steps not directly modeled.

Thus, plots may be provided for multiple possible steps- e.g. 0V to 200V, 50V to 200V, 100V to 200V, 150V to 200V etc.

The limited number of measurements needed to create the logarithmic plots can be repeated on a regular basis as part of an initial device modeling procedure so that the functions can be adjusted during the life time of the actuator system.

For example, a fixed set of look-up tables may be provided which switch as the device is used more. This usage may be monitored by logging the voltage and actuation times in the driver and switching after a certain threshold is reached which relates to the product of these values. Another option is to provide a calibration device which carries out a few measurements (i.e. just a single curve of the type described in Figure 8) and chooses the most suitable look-up table based on that calibration. Thus, periodic recalibrations may be performed, for instance a yearly service calibration.

Making use of this updated function will provide input about the displacement which is expected during a delay period, which can then be used to accurately drive the actuator to a next defined position.

The updated function can also be used to determine a specific time at which the actuator reaches its final position and the precise time-displacement characteristics. This can be used to differentiate between a fast response and slow response towards the same end state for a given step input. The delay may also be selected in such a way that a defined position is reached before a next driving signal is provided.

Note that in order to reach a desired actuation state after a set delay period, the drive scheme may result in overdriving of the actuator to a higher voltage than the voltage associated with the final desired end displacement. Thus, the waveform which is used may not simply transition from the first drive voltage (associated with the first actuation state) to the second drive voltage (associated with the second actuation state).

The relative displacement of the actuator between each voltage step when the delays are present remains relatively stable for a number of actuations. However, a drift is observed in the absolute displacement (although not easily seen in the Figures).

The absolute displacement (y_abs) can be more precisely calculated as a function of the number of actuation cycles after the run in cycles of the EAP using the function: y_abs = c*n + y_rel,
where y_rel is the relative displacement noted in Table 1, n is the number of cycles after the run in actuation and c is a constant.

The displacement predicted by the look up table data can thus be modified to take account of the number of actuation cycles using this linear correction.

The first example above takes account of how long the actuator is held at a particular drive voltage and hence actuation state. However, the history before the transition to that particular drive voltage also has an influence, in particular the delay history. This history gives a delay-dependent hysteresis profile.

For a second example, the situation is considered that the actuator is driven from one state to another state after a defined delay: in other words where there is a delay between a first actuation transition and a second actuation transition, where the effect on the second transition is influenced by the delay.

When previous delay-times increase, a less steep (lower slope) rate of change of actuation with time is observed.

Table 2 below shows how the slope in the hysteresis changes as a function of delay-time. The top row shows delay times in seconds.

The slopes are the gradients of the µm/V graphs between the fixed voltage points. For example, with reference to Figure 6C, in particular the bottom left branch, if -100V is applied for 2 seconds and then sweeps to -50V, the rate of change of actuation with voltage is much slower - the slope is lower. The slopes for the 0.1 second delays of Figure 6B are between and hence closer to the no wait situation. This is the same for all these intermediate rates of change after a waiting period. Thus, if the known slope without waiting period is used (Figure 6A) to interpolate after a 2 second wait then it would result in significant over-estimation of the actuation.

For the purposes of explanation, it is assumed that in a small voltage range (such as 50V - but this will depend upon the actuator) the displacement behaves in a linear way.

**Table 2**

| | 0 | 0.1 | 0.5 | 0.67 | 1 | 2 | 10 | 20 |
|---|---|---|---|---|---|---|---|---|
| 50V-100V | 0.0021 | 0.0015 | 0.0014 | 0.001 | 0.0011 | 0.001 | 0.0012 | 0.0011 |
| 100V-150V | 0.0037 | 0.0031 | 0.0029 | 0.0028 | 0.0029 | 0.0029 | 0.0026 | 0.0027 |
| 150V-200V | 0.0066 | 0.0055 | 0.0047 | 0.0051 | 0.005 | 0.0047 | 0.0044 | 0.0045 |

This table shows the slope (in µm/V) of the hysteresis plot for different delays before the initial transition to the new drive voltage. For each voltage range, the slope stabilizes at higher delay times. The slope stabilizes after a time because the maximum polarization has been reached at the initial voltage.

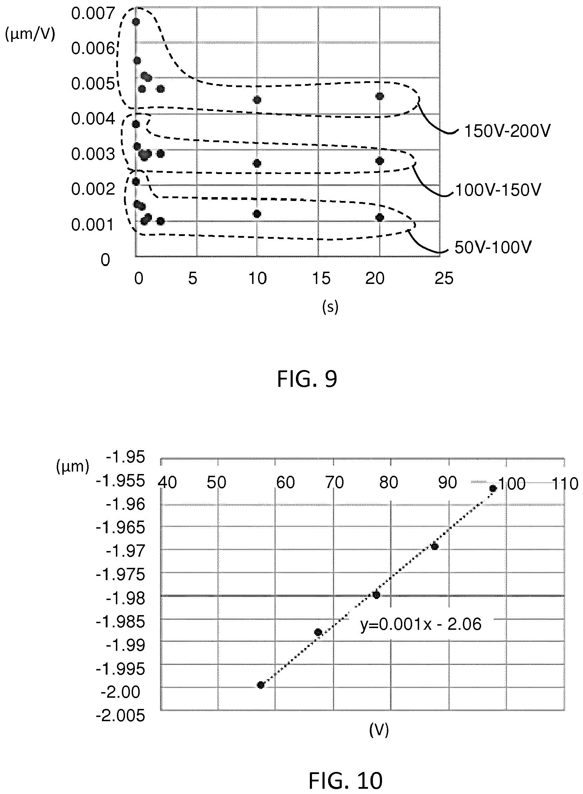

Figure 9 shows the slope (in µm/V) of different voltage ranges as a function of a previous delay (in seconds).

This data can also be translated to the look-up table so that the previous delay, which is part of the actuation history, is translated to a slope which can be used to exactly drive the actuator to a certain position by selecting a suitable time and/or driving voltage.

Thus, in this example, the look up table additionally stores data representing the effect of a hold period at the first actuation state before driving to the second actuation state.

In another example, the delay dependent input (i.e. the information of Figure 8) is combined with the hysteresis profile dependency on the driving history (i.e. the information of Figure 9).

Figure 10 shows the change in displacement for a voltage step from 50V to 100V and shows the linear behavior of displacement vs. voltage in this limited voltage range of 50V.

The intermediate voltages are driven hence the different points in the graph. The voltage sweeps from 50V to 100V in about 50ms (the total sawtooth waveform is 1 second - 1Hz - as shown in Figure 4). The positions can thus be obtained from the graphs of Figures 6B and 6C.

The linear function for this voltage step is in the form: y = ax + b.

In this case, y = displacement, x is the voltage and b defines the displacement starting value. Thus, the value b determines the position of the linear function on the y-axis (displacement axis).

In this equation, b is directly influenced by the delay-history, since longer delays lead to more displacement and thus another value for b. There is a linear correlation between the delay time history and the value for b.

As an example, a series of delays at 150V is considered before driving the actuator actively from 150V-200V.

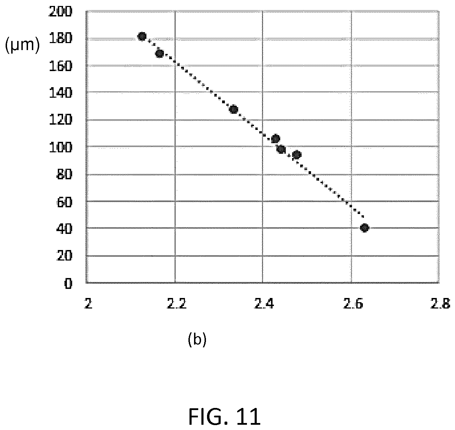

Figure 11 shows effect of different delays (the different plotted points) on the value of b. The value of b is on the x-axis, and relates to driving from 150V to 200V and the y-axis plots the displacement at the starting voltage of 150V.

The value of b has a linear dependency with the delay-time history (during a delay, displacement continues). As shown in Figure 10, it can be seen that b has a value of -2.06 (for this specific case). If the delay before this voltage step (50V-100V) was longer (for a different delay history), b would have been more negative, decreasing the displacement and changing the slope.

Figure 11 is for a different voltage-step (150V-200V), but the same behavior applies. With a short delay before this voltage step, b has a value of 2.12, resulting in a displacement of approximately 180µm. With a long delay before the voltage step (for example the last data point), b has a value of 2.63, resulting in a displacement of approximately 40µm.

The logarithmic function to determine the displacement during a delay at a desired static voltage can directly be used as input for the linear function when actively driving the actuator to a new voltage.

The system may thus combine use of a linear function (which captures delay history information) and a logarithmic function (which captures drive response to a static drive voltage). The logarithmic function of the first example becomes the input to the linear hysteresis function of the second example.

Thus, in a first example of the invention the situation is considered that the actuator is experiencing a delay at a static voltage. This then also determines the starting value of the displacement in the linear function used in the second example. At the same time, the delay also determines the value of b of the linear function.

Thus, when both values are provided in a look-up table, it can exactly describe the displacement during the active driving (for instance, from 100V-150V) via the linear delay history function.

The look-up table can effectively be created using only a small number of reference measurements, which then enable the two functions to be derived. A set of reference measurements enable extrapolation to any desired actuation profile.

As mentioned above, the final drive scheme, which aims to reach a target actuation level at a target time, will result in a certain degree of overdriving, i.e. the actuator may be temporarily driven to a voltage higher than the equilibrium voltage in order to compensate for a shorter delay time.

The lookup table can be extended to account for the polarity of the previous derive level if required. Reversing polarity would be like a more excessive case of reducing the voltage - not only do the polarized areas depolarize but now the driving voltage is actively driving them to the new situation. Effectively this will take a little longer time to reach a steady state.

This invention relates in particular to actuation of EAP actuators comprising EAP as part of an EAP structure. The EAP structure thus comprises an EAP material. This is a material that can make the EAP structure deform upon providing an electrical signal to the EAP structure. As such the EAP material can be a mixture (homogeneous or heterogeneous) comprising or consisting of one or more matrix materials with one or more EAPs. This can for example be an EAP dispersion in a further polymer matrix material. The further polymer matrix material can be a network polymer that allows deformation invoked by the EAP mixed in or dispersed within the matrix network. The EAP material can be dispersed in it. Elastic materials are examples of such networks. Preferably the amount of EAP in such composite EAP materials is chosen from the group consisting of >50 weight or mole percent, >75 weight or mole percent or >90 weight or mole percent. EAP materials can also comprise polymers that contain in their molecules parts of EAPs (or EAP active groups) and parts of inactive other polymers. Many electroactive polymers can be used a number of which will be described below.

The invention relates specifically to field-driven EAPs and those showing remnant polarization as a function of electric field.

They may comprise piezoelectric and electrostrictive polymers. While the electromechanical performance of traditional piezoelectric polymers is limited, a breakthrough in improving this performance has led to PVDF relaxor polymers, which show spontaneous electric polarization (field driven alignment). These materials can be pre-strained for improved performance in the strained direction (pre-strain leads to better molecular alignment).

This film metal electrodes are typically used since strains usually are in the moderate regime (1-5%), also other types of electrodes, such as e.g. conducting polymers, carbon black based oils, gels or elastomers, etc. can also be used.

The sub-class electrostrictive polymers includes, but is not limited to: Polyvinylidene fluoride (PVDF), Polyvinylidene fluoride - trifluoroethylene (PVDF-TrFE), Polyvinylidene fluoride - trifluoroethylene - chlorofluoroethylene (PVDF-TrFE-CFE), Polyvinylidene fluoride - trifluoroethylene - chlorotrifluoroethylene) (PVDF-TrFE-CTFE), Polyvinylidene fluoride- hexafluoropropylene (PVDF - HFP), polyurethanes or blends thereof.

Additional passive layers may be provided for influencing the electrical and/or mechanical behavior of the EAP material layer in response to an applied electric field or current.

The EAP material layer of each unit may be sandwiched between electrodes. Alternatively, electrodes can be on a same side of the EAP material. In either case, electrodes can be physically attached to the EAP material either directly without any (passive) layers in between, or indirectly with additional (passive) layers in between. But this need not always be the case. For relaxor or permanent piezoelectric or ferroelectric EAPs, direct contact is not necessary. In the latter case electrodes in the vicinity of the EAPs suffices as long as the electrodes can provide an electric field to the EAPs, the EAP structure will have its actuation function. Materials suitable for the electrodes are also known, and may for example be selected from the group consisting of thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS). Metalized polyester films may also be used, such as metalized polyethylene terephthalate (PET), for example using an aluminum coating.

An EAP structure may thus be used for actuation. Alternatively or additionally it may be used for sensing. The most prominent sensing mechanisms are based on force measurements and strain detection. Piezoelectric and electrostrictive polymer sensors can generate an electric charge in response to applied mechanical stress (given that the amount of crystallinity in the piezoelectric EAP is high enough to generate a detectable charge). C The invention can be applied in many EAP actuator systems, including examples where a matrix array of actuators is of interest.

In many applications, the main function of the product relies on the (local) manipulation of human tissue, or the actuation of tissue contacting interfaces. In such applications EAP actuators for example provide unique benefits mainly because of the small form factor, the flexibility and the high energy density. Hence they can be easily integrated in soft, 3D-shaped and / or miniature products and interfaces. Examples of such applications are:
Skin cosmetic treatments such as skin actuation devices in the form of a responsive polymer based skin patches which apply a constant or cyclic stretch to the skin in order to tension the skin or to reduce wrinkles;
Respiratory devices with a patient interface mask which has a responsive polymer based active cushion or seal, to provide an alternating normal pressure to the skin which reduces or prevents facial red marks;
Electric shavers with an adaptive shaving head. The height of the skin contacting surfaces can be adjusted using responsive polymer actuators in order to influence the balance between closeness and irritation;
Oral cleaning devices such as an air floss with a dynamic nozzle actuator to improve the reach of the spray, especially in the spaces between the teeth. Alternatively, toothbrushes may be provided with activated tufts;
Consumer electronics devices or touch panels which provide local haptic feedback via an array of responsive polymer transducers which is integrated in or near the user interface;
Catheters with a steerable tip to enable easy navigation in tortuous blood vessels.

Another category of relevant application which benefits from such actuators relates to the modification of light. Optical elements such as lenses, reflective surfaces, gratings etc. can be made adaptive by shape or position adaptation using these actuators. Here one benefit of EAPs for example is a lower power consumption.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

Summarizing, an electroactive polymer actuator comprises an electroactive polymer structure and a driver for providing an actuation drive signal. In one aspect a first drive signal with an overdrive voltage is used to change the charge of the electroactive polymer structure needed for switching the structure from one to another actuation state. When or after the electroactive polymer structure actuation is near or at the another actuation state, a drive voltage is used to bring to and hold the electroactive polymer structure at the actuated state. This temporary overdrive scheme improves the speed response without damaging the electroactive polymer structure.

## Claims

1. An actuator device comprising:
an electroactive polymer structure (70) for adopting at least a first actuation state and a second actuation state different from the first actuation state, the first actuation state having a first drive voltage associated with it and the second actuation state having a second drive voltage associated with it;
a driver (72) adapted to apply the drive voltages to the electroactive polymer structure for switching it from the first actuation state to the second actuation state;
a look up table (74) which stores look up table data which represents the change in actuation level over time after actuation from the first drive voltage to the second drive voltage; and
a controller (76) to control the driver to apply a drive waveform for transitioning between the first and second actuation states which takes into account the look up table data.

2. A device as claimed in claim 1, wherein the look up table (74) stores a set of discrete actuation level points over time of a logarithmic function, for the drive voltage for each of a plurality of different first and second drive voltages.

3. A device as claimed in claim 1 or 2, wherein the look up table (74) stores data representing the effect of a hold period at the first actuation state before driving to the second actuation state.

4. A device as claimed in claim 3, wherein the data representing the effect of the hold period comprises a slope of the function of displacement versus actuation voltage level.

5. A device as claimed in claim 3 or 4, wherein the data representing the effect of the hold period comprises a starting value of the displacement when the transition from the first actuation state to the second actuation state commences.

6. A device as claimed in any preceding claim, wherein the electroactive polymer structure comprises a field-driven electroactive polymer.

7. A device as claimed in claim 6, wherein the field-driven electroactive polymer comprises a PVDF relaxor polymer actuator.

8. A method of driving an actuator device which comprises an electroactive polymer structure for adopting at least a first actuation state and a second actuation state different from the first actuation state, the first actuation state having a first drive voltage associated with it and the second actuation state having a second drive voltage associated with it, wherein the method comprises:
applying a first drive voltage to the electroactive polymer structure for holding it in the first actuation state; and
providing a voltage waveform between the first drive voltage and a second drive voltage for driving the actuator device to the second actuation state,
wherein the voltage waveform is determined by addressing a look up table which stores look up table data which represents the change in actuation level over time after actuation from the first drive voltage to the second drive voltage.

9. A method as claimed in claim 8, comprising forming a logarithmic function of the actuation level over time for each of a plurality of different first and second actuation states, by extrapolating between a set of discrete points.

10. A method as claimed in claim 8 or 9, comprising storing in the look up table data representing the effect of a hold period at the first actuation state before driving to the second actuation state.

11. A method as claimed in claim 10, wherein the data representing the effect of the hold period comprises a slope of the function of displacement versus actuation voltage level.

12. A method as claimed in claim 10 or 11, wherein the data representing the effect of the hold period comprises a starting value of the displacement when the transition from the first actuation state to the second actuation state commences.

13. A method as claimed in any one of claims 8 to 12, wherein the electroactive polymer structure comprises a field-driven electroactive polymer, such as a PVDF relaxor polymer actuator.

14. A computer program product comprising computer readable code stored on, or storable on a computer readable medium, or downloadable from a communications network, which computer readable code, when run on a computer, causes a driver to perform the steps of the methods of any one of claims 10 to 13.
